# EUROPÄISCHE PATENTSCHRIFT

(11) **EP 3 631 976 B1**
(45) Veröffentlichungstag und Bekanntmachung des Hinweises auf die Patenterteilung: **28.10.2020**
(21) Anmeldenummer: 18729392.3
(22) Anmeldetag: 04.06.2018
(51) Int. Cl.: H02S 50/10

(54) **VERFAHREN ZUR ERKENNUNG EINES KONTAKTFEHLERS IN EINER PHOTOVOLTAIKANLAGE**
METHOD FOR DETECTING A CONTACT FAULT IN A PHOTOVOLTAIC SYSTEM
PROCÉDÉ SERVANT À IDENTIFIER UN CONTACT DÉFECTUEUX DANS UNE INSTALLATION PHOTOVOLTAÏQUE

(30) Priorität: 02.06.2017 DE 102017112256
(43) Veröffentlichungstag der Anmeldung: 08.04.2020
(73) Patentinhaber: SMA Solar Technology AG, 34266 Niestetal (DE)
(72) Erfinder: HOPF, Markus, 34314 Espenau (DE)
(86) Internationale Anmeldenummer: PCT/EP2018/064589
(87) Internationale Veröffentlichungsnummer: WO 2018/220223

(56) Entgegenhaltungen:
- EP-A1- 2 388 602
- DE-A1-102009 044 057

## Beschreibung

### TECHNISCHES GEBIET DER ERFINDUNG

Die Erfindung betrifft ein Verfahren zum Betrieb einer Photovoltaikanlage, die zur Einspeisung elektrischer Leistung in ein Wechselspannungsnetz eingerichtet i ist und einen Wechselrichter für eine Photovoltaikanlage.

### STAND DER TECHNIK

Ein Kontaktfehler in einem Gleichstromkreis einer Photovoltaikanlage kann eine erhebliche Erwärmung der Umgebung der Fehlerstelle hervorrufen und zu einer Lichtbogenbildung führen. Neben einem Funktionsausfall, insbesondere einer Unterbrechung des Gleichstromkreises, können dadurch hohe Schäden hervorgerufen werden, und im Extremfall kann ein Brand der Photovoltaikanlage entstehen. Um dieses Risiko zu minimieren, sind verschiedene Verfahren zur frühzeitigen Erkennung eines Kontaktfehlers bekannt.

Grundsätzlich zeichnet sich ein Kontaktfehler durch eine Änderung des Serienwiderstandes des betroffenen Bauteiles aus. Daher basieren viele der bekannten Verfahren zur Kontaktfehlererkennung auf einer Modellierung und Analyse der Impedanz des Gleichstromkreises der Photovoltaikanlage. Zur Gesamtimpedanz des Gleichstromkreises trägt eine Reihe von Komponenten des Gleichstromkreises bei, darunter insbesondere die Gleichstromleitungen und die Photovoltaikgeneratoren selbst. Darüber hinaus sind die Impedanzen mancher dieser Komponenten temperaturabhängig, und die Impedanz der Photovoltaikgeneratoren unterliegt Alterungseffekten, insbesondere der sogenannten potential-induzierten Degradation, durch die eine Impedanzänderung hervorgerufen werden kann, die einer durch einen Kontaktfehler hervorgerufenen Impedanzänderung stark ähnelt. Ein weiterer Nachteil der bekannten Verfahren liegt in der Beeinflussung der Impedanzanalyse durch den Betrieb der Photovoltaikanlage, so dass die bekannten Verfahren nur in Zeiten ohne solare Einstrahlung auf die Photovoltaikgeneratoren ausgeführt werden können, insbesondere also nur nachts. Dabei ist zu beachten, dass in diesen Zeiten keine Leistung aus den Photovoltaikgeneratoren zur Verfügung steht, so dass eine zusätzliche Energiequelle zur Durchführung der bekannten Verfahren zur Kontaktfehlererkennung bereitgestellt werden muss.

Aus der WO2012000533A1 ist ein Verfahren zur Überwachung einer Photovoltaikanlage bekannt, bei der mittels eines Signaleinkopplungsmittels ein Testsignal in einen Photovoltaikgenerator eingespeist und mittels eines Signalauskopplungsmittels ein Antwortsignal ausgekoppelt wird, wobei im Falle mehrerer parallel verschalteter Photovoltaikgeneratoren je ein Paar aus Signaleinkopplungsmittel und Signalauskopplungsmittel zur Ein- und Auskopplung je eines Testsignals pro Photovoltaikgenerator vorgesehen ist.

Aus der EP2388602A1 ist ein Verfahren zur Diagnose von Kontakten einer Photovoltaikanlage bekannt, bei dem ein mehrere Frequenzen umfassendes Testsignal in Gleichstromleitungen eingekoppelt, ein Antwortsignal aus der Photovoltaikanlage ausgekoppelt und eine Generatorimpedanz mittels einer Auswertung des Antwortsignals ermittelt wird. Zur Überwachung der Kontakte wird das Wechselstromverhalten der Photovoltaikanlage anhand eines Betrages und einer Phaseninformation der ermittelten Generatorimpedanz modelliert und aus dem Modell eine Serienimpedanz ermittelt, die Informationen über den Zustand der Kontakte beinhaltet. Ein vergleichbares Verfahren ist auch aus der EP2388603A1 bekannt.

### AUFGABE DER ERFINDUNG

Der Erfindung liegt die Aufgabe zugrunde, ein Verfahren zum Erkennen eines Kontaktfehlers in einer Photovoltaikanlage und einen Wechselrichter für eine Photovoltaikanlage bereitzustellen, so dass die Brandsicherheit verbessert und das Monitoring von Photovoltaikanlagen einfacher und robuster als mit aus dem Stand der Technik bekannten Verfahren ausgeführt werden kann.

### LÖSUNG

Die Aufgabe wird durch ein Verfahren zum Erkennen eines Kontaktfehlers in einer Photovoltaikanlage mit den Merkmalen des Patentanspruchs 1 und einen Wechselrichter gemäß Anspruch 2 gelöst. Bevorzugte Ausführungsformen sind in Anspruch 3 definiert.

### BESCHREIBUNG DER ERFINDUNG

Bei einem erfindungsgemäßen Verfahren zur Erkennung eines Kontaktfehlers in einer Photovoltaikanlage umfasst die Photovoltaikanlage einen Wechselrichter und einen über Gleichstromleitungen mit dem Wechselrichter verbundenen Photovoltaikgenerator. Der Wechselrichter umfasst Einkoppelmittel zum Einkoppeln eines ersten Wechselspannungssignals mit Kommunikationsfrequenzen in einem ersten Frequenzbereich zwischen 125 und 150 kHz in die Gleichstromleitungen. Mittels des ersten Wechselspannungssignals kommuniziert der Wechselrichter mit dem Photovoltaikgenerator, wobei an dem Photovoltaikgenerator ein Auskoppelmittel zum Auskoppeln des ersten Wechselspannungssignals angeordnet ist, so dass der Photovoltaikgenerator von einer Übertragungsstrecke zwischen Wechselrichter und dem Entkoppelmittel entkoppelt ist. Weiterhin ist zwischen dem Wechselrichter und dem Photovoltaikgenerator ein Entkoppelmittel zur Entkoppelung der Impedanz des Photovoltaikgenerators angeordnet, und es werden Wechselströme in und Wechselspannungen zwischen den Gleichstromleitungen gemessen.

Mittels des Einkoppelmittels wird ein zweites Wechselspannungssignal mit Messfrequenzen erzeugt, wobei mittels des zweiten Wechselspannungssignals und der gemessenen Wechselströme ein frequenzabhängiger Impedanzverlauf in einem zweiten Frequenzbereich zwischen 50 kHz und 350 kHz, bevorzugt zwischen 75 kHz und 200 kHz bestimmt wird, und wobei der zweite Frequenzbereich den ersten Frequenzbereich umfasst. Abschließend wird ein Kontaktfehler in der Photovoltaikanlage mittels einer Analyse des Impedanzverlaufes erkannt.

Durch das Einbringen des Entkoppelmittels zwischen den Wechselrichter und den Photovoltaikgenerator, sowie aufgrund von Resonanzeigenschaften des Auskoppelmittels ergibt sich in dem ersten Frequenzbereich zwischen 125 und 150 kHz ein definierter Verlauf der Impedanz der Übertragungsstrecke zwischen dem Einkoppelmittel und dem Auskoppelmittel. Dieser definierte Verlauf der Impedanz wird dazu genutzt, einen stabilen Kommunikationskanal zwischen dem Wechselrichter und dem Photovoltaikgenerator bereitzustellen.

Die Erfindung beruht auf der Erkenntnis, dass der definierte Verlauf der Impedanz erhebliche Vorteile bietet, die über die Bereitstellung des stabilen Kommunikationskanals hinausgehen. Insbesondere liegen der erste und der zweite Frequenzbereich deutlich unterhalb von Frequenzbereichen, in denen die Gleichstromleitungen zwischen Wechselrichter und Photovoltaikgenerator üblicherweise Resonanzeffekte hervorrufen; letztere liegen in der Regel deutlich oberhalb von 300 kHz. Darüber hinaus wirkt das Entkoppelmittel als Bypass für die Wechselspannungssignale, so dass diese den Photovoltaikgenerator nicht erreichen und etwaige Resonanzeffekte des Photovoltaikgenerators keinen Einfluss auf die Übertragungsstrecke zwischen Einkoppelmittel und Auskoppelmittel haben. Die Impedanz des Photovoltaikgenerators wird durch das Entkoppelmittel wirksam von der Übertragungsstrecke zwischen Wechselrichter und Entkoppelmittel abgeschirmt.

Somit ist der Verlauf der Impedanz im zweiten Frequenzbereich zwischen 50 kHz und 350 kHz und insbesondere zwischen 75 kHz und 200 kHz nahezu ausschließlich durch die Leitungsimpedanzen der Gleichstromleitungen sowie etwaige Serienimpedanzen von Kontaktstellen in der Strecke vom Wechselrichter über die Gleichstromleitungen zum Entkoppelmittel bestimmt. Dieser Verlauf der Impedanz im zweiten Frequenzbereich ist insbesondere in Abwesenheit von Kontaktstellen weitgehend konstant und insbesondere nicht durch temperatur-, einstrahlungs- oder lastabhängige Impedanzen des Photovoltaikgenerators oder Resonanzstellen der Gleichstromleitungen beeinflusst.

Das erfindungsgemäße Verfahren kann besonders vorteilhaft mit einem an sich bekannten Verfahren zur Impedanzspektroskopie kombiniert werden, wie es beispielsweise aus der EP2388602A1 bekannt ist. Der aus den gemessenen Wechselströmen und Wechselspannungen ermittelte Verlauf der Impedanz wird dabei gegebenenfalls unter Berücksichtigung der Gleichspannung am Eingang des Wechselrichters beispielsweise mit Hilfe eines vorab oder situativ bestimmten Modellansatzes analysiert, und es wird daraus die Serienimpedanz der Gleichstromleitungen inklusive der Kontaktstellen, insbesondere derjenigen an den Anschlüssen des Wechselrichters und am Entkoppelmittel bestimmt. Diese Serienimpedanz enthält alle notwendigen Informationen, um einen Kontaktfehler erkennen zu können.

Ein erfindungsgemäßer Wechselrichter umfasst eine Steuerung, die dazu eingerichtet ist, das erfindungsgemäße Verfahren durchzuführen. Dazu umfasst der Wechselrichter ein Einkoppelmittel zum Einkoppeln eines ersten Wechselspannungssignals mit Kommunikationsfrequenzen in einem ersten Frequenzbereich zwischen 125 und 150 kHz in die Gleichstromleitungen, so dass der Wechselrichter in der Lage ist, mittels des ersten Wechselspannungssignals mit dem Photovoltaikgenerator zu kommunizieren. Weiterhin umfasst der Wechselrichter Strom- und Spannungssensoren zur Messung eines Stromes in beziehungsweise einer Spannung zwischen Gleichstromleitungen, die an Gleichstromanschlüssen des Wechselrichters angeschlossen sind.

In einer Ausführungsform der Erfindung umfasst der Wechselrichter Anschlüsse zum Anschluss mehrerer Photovoltaikgeneratoren, wobei die Photovoltaikgeneratoren innerhalb des Wechselrichters oder in einer zum Wechselrichter gehörigen Anschlusseinheit parallel geschaltet sind. Dabei ist jedem Photovoltaikgenerator je ein Strommessmittel innerhalb der Wechselrichters oder der Anschlusseinheit zugeordnet. Das Einkoppelmittel jedoch ist innerhalb des Wechselrichters oder der Anschlusseinheit derart zentral angeordnet, dass das erste und das zweite Wechselspannungssignal im Betrieb des Wechselrichters gleichzeitig in die zu den parallel geschalteten Photovoltaikgeneratoren führenden Gleichstromleitungen eingekoppelt wird. Dadurch wird es besonders einfach, die Erkennung von Kontaktfehlern für eine Anzahl separat angeschlossener Photovoltaikgeneratoren durchzuführen, ohne für jeden der Photovoltaikgeneratoren ein eigenes Einkoppelmittel vorsehen zu müssen, wie es bei herkömmlichen Wechselrichtern und entsprechenden Verfahren notwendig ist.

### KURZBESCHREIBUNG DER FIGUREN

Im Folgenden wird die Erfindung anhand in den Figuren dargestellter Ausführungsbeispiele weiter erläutert und beschrieben.
- Fig. 1: zeigt eine Photovoltaikanlage mit einem Wechselrichter, einem Photovoltaikgenerator und Vorrichtungen zur Durchführung des erfindungsgemäßen Verfahrens,
- Fig. 2: zeigt ein Beispiel eines frequenzabhängigen Impedanzverlaufs einer Übertragungsstrecke zwischen dem Wechselrichter und dem Photovoltaikgenerator,
- Fig. 3: zeigt eine Ausführungsform des erfindungsgemäßen Verfahrens in Form eines Flussdiagramms, und
- Fig. 4: zeigt eine weitere Ausführungsform einer Photovoltaikanlage.

### FIGURENBESCHREIBUNG

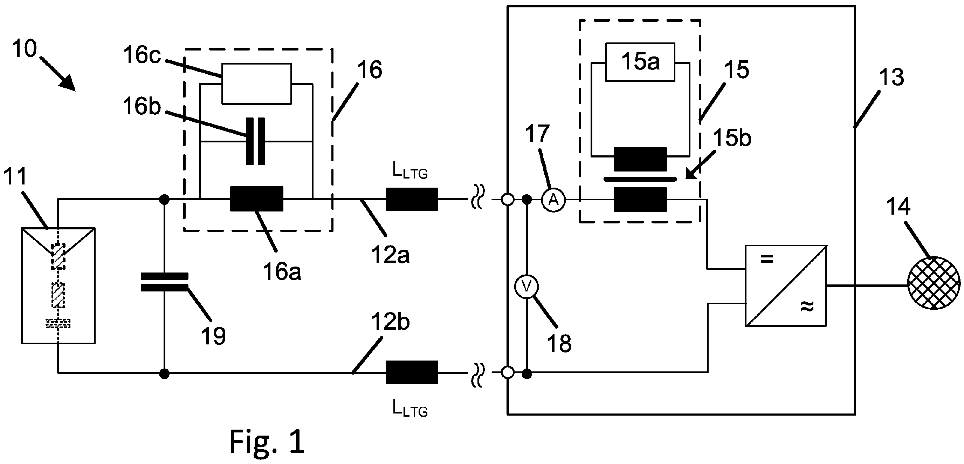

**Fig. 1** zeigt eine Photovoltaikanlage 10 mit einem Photovoltaikgenerator (PV-Generator) 11, der aus einem oder mehreren parallel und/oder in Reihe geschalteten PV-Modulen bestehen kann und über Gleichstromleitungen 12a, 12b an einen Wechselrichter 13 angeschlossen ist. Der Wechselrichter 13 wandelt den vom PV-Generator 11 erzeugten Gleichstrom in Wechselstrom um und speist diesen in ein Wechselspannungsnetz 14 ein.

Der Wechselrichter 13 umfasst ein Einkoppelmittel 15 zum Einkoppeln eines Wechselspannungssignals in eine der Gleichstromleitungen 12a, 12b. Das Einkoppelmittel 15 kann in verschiedenen Formen ausgeführt sein, beispielsweise wie in Fig. 1 dargestellt mit einer Wechselspannungsquelle 15a, die an eine Primärseite eines Übertragers 15b angeschlossen ist, wobei die Sekundärseite des Übertragers 15b derart in die Gleichstromleitung 12a eingebunden ist, dass in die Gleichstromleitung 12a ein Wechselspannungssignal eingekoppelt wird. Weitere Ausführungsformen des Einkoppelmittels 15 sind dem Fachmann bekannt.

Das derart eingekoppelte Wechselspannungssignal wird über die Gleichstromleitungen 12a, 12b zum PV-Generator 11 übertragen. In der Nähe des PV-Generators 11, beispielsweise in einer Anschlussdose eines Photovoltaikmoduls des PV-Generators 11, ist ein Auskoppelmittel 16 angeordnet. Das Auskoppelmittel 16 kann in verschiedenen Formen ausgeführt sein, beispielsweise wie in Fig. 1 dargestellt als RLC-Parallelschwingkreis mit einer in der Gleichstromleitung 12a angeordneten Induktivität 16a sowie einer Kapazität 16b und einem Widerstand 16c, die jeweils elektrisch parallel zur Induktivität 16a angeordnet sind; alternativ sind andere Ausführungsformen für das Auskoppelmittel 16 denkbar, beispielsweise ein Serienschwingkreis. Mittels einer nicht dargestellten Spannungsmessung kann das zum PV-Generator 11 übertragene Wechselspannungssignal am Auskoppelmittel 16 abgegriffen werden, beispielsweise als Spannungsabfall am Widerstand 16c oder parallel zum Auskoppelmittel 16 und einem Entkoppelmittel 19.

Der Frequenzverlauf einer Übertragungsfunktion für das Wechselspannungssignal hängt direkt vom frequenzabhängigen Verlauf der Impedanz der Übertragungsstrecke zwischen dem Einkoppelmittel 15 und dem Auskoppelmittel 16 ab. Die Impedanz der Übertragungsstrecke setzt sich dabei aus mehreren Anteilen zusammen, die insbesondere Leitungsimpedanzen L_{LTG} der Gleichstromleitungen 12a, 12b, etwaige Serienimpedanzen von Kontaktstellen, sowie in herkömmlichen Photovoltaikanlagen auch die Impedanz des PV-Generators 11 umfassen. Das Entkoppelmittel 19, das zwischen Auskoppelmittel 16 und PV-Generator 11 angeordnet ist, dient zur Entkopplung der komplexen und zudem zeitlich veränderlichen Impedanz des PV-Generators 11, so dass die Impedanz des PV-Generators 11 von der Übertragungsstrecke zwischen Einkoppelmittel 15 und Auskoppelmittel 16 entkoppelt ist. Dadurch wird ein definierter Impedanzverlauf zwischen Einkoppelmittel 15 und Auskoppelmittel 16 erzeugt, wobei der Impedanzverlauf insbesondere bei Abwesenheit von Kontaktfehlern zeitlich weitgehend konstant ist. Eine solche Übertragungsstrecke mit einem definierten Impedanzverlauf insbesondere im Bereich ausgewählter Frequenzen ist besonders gut für eine Kommunikation zwischen dem Einkoppelmittel 15 und dem Auskoppelmittel 16 geeignet. Im Ergebnis lässt sich ein definierter und begrenzter Empfangspegelbereich berechnen und angeben, und das Verhältnis aus minimalem Empfangspegel zu maximalem Empfangspegel wird kleiner.

Das vom Einkoppelmittel 15 über die Gleichstromleitungen 12a, 12b an das Auskoppelmittel 16 übertragene Wechselspannungssignal kann zur unidirektionalen Kommunikation mit einer weiteren, am PV-Generator 11 angeordneten elektrischen oder elektronischen Schaltung verwendet werden (in Fig. 1 nicht dargestellt). Beispielsweise kann ein Freischalter oder ein Kurzschlussschalter am PV-Generator 11 angeordnet sein, dessen Schaltzustand mittels eines vom Einkoppelmittel 15 in die Gleichstromleitungen 12a, 12b eingekoppelten und gegebenenfalls codierten Wechselspannungssignals gesteuert wird.

Der Wechselrichter 13 umfasst weiterhin ein Strommessmittel 17 sowie ein Spannungsmessmittel 18. Das Strommessmittel 17 ist in einer der Gleichstromleitungen 12a, 12b angeordnet und zur Messung des in den Gleichstromleitungen 12a, 12b fließenden Stromes eingerichtet. Dieser Strom kann neben dem vom PV-Generator 11 erzeugten Gleichstrom auch Wechselstromkomponenten aufweisen, die aufgrund des von dem Einkoppelmittel 15 eingekoppelten Wechselspannungssignals in den Gleichstromleitungen 12a, 12b induziert werden. Alternativ kann der Wechselrichter 13 auch mehrere Strommessmittel 17 aufweisen, beispielsweise ein auf die Messung von Gleichströmen optimiertes Strommessmittel 17 und mindestens ein weiteres auf die Messung von Wechselströmen in einem Frequenzbereich des zweiten Wechselspannungssignals optimiertes Strommessmittel 17.

Das Spannungsmessmittel 18 ist zwischen den Gleichstromleitungen 12a, 12b angeordnet und zur Messung der Potentialdifferenz zwischen den Gleichstromleitungen 12a und 12b eingerichtet. Wie bei dem Strommessmittel 17 kann der Wechselrichter 13 auch mehrere Spannungsmessmittel 18 umfassen, die jeweils zur Messung von Gleichspannungen bzw. von Wechselspannungen in einem oder mehreren Frequenzbereichen optimiert sind.

An dem PV-Generator 11 ist ein Entkoppelmittel 19 angeordnet. Das Entkoppelmittel 19 bietet den vom Einkoppelmittel 15 in den Gleichstromleitungen 12a, 12b erzeugten Wechselströmen einen Bypass zum PV-Generator 11, so dass diese Wechselströme nicht über den PV-Generator 11 fließen müssen und der PV-Generator 11 somit bezüglich Wechselspannungen und Wechselströmen in den Gleichstromleitungen 12a, 12b entkoppelt ist.

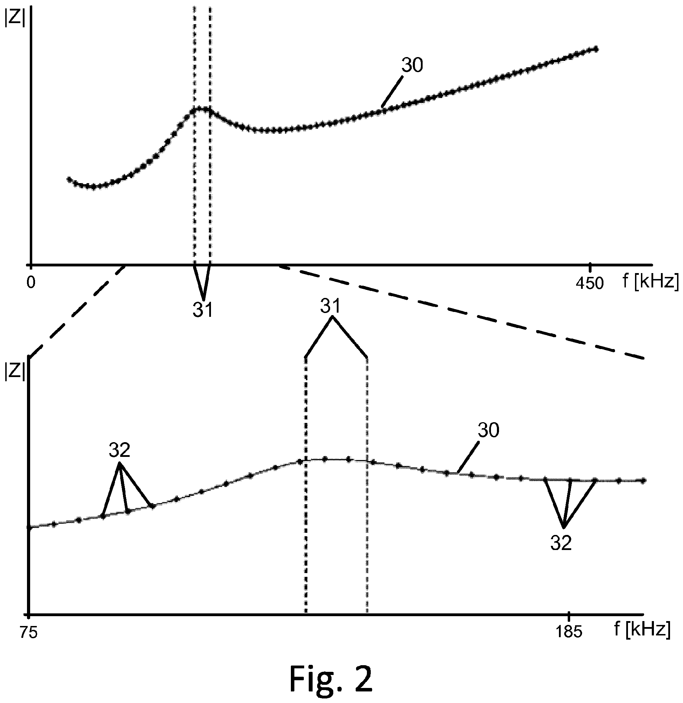

**Fig. 2** zeigt einen beispielhaften Impedanzverlauf 30 des Betrages der Impedanz |Z| der Übertragungsstrecke bestehend aus Gleichstromleitungen 12a, 12b, Auskoppelmittel 16 und Entkoppelmittel 19, sowie angrenzender Kontaktstellen. Aufgrund des Entkoppelmittels 19 ist der Impedanzverlauf 30 der Impedanz |Z| nicht von der Impedanz des PV-Generators 11 beeinflusst.

Im oberen Teil der Fig. 2 ist der Impedanzverlauf 30 des Betrages der Impedanz |Z| über einen Frequenzbereich von etwa 50 kHz bis 450 kHz dargestellt. Ein erstes Wechselspannungssignal, das zur Kommunikation zwischen dem Einkoppelmittel 15 und dem Auskoppelmittel 16 vorgesehen ist, kann durch das Einkoppelmittel 15 in die Gleichstromleitungen 12a, 12b eingespeist werden und ausgewählte Kommunikationsfrequenzen 31 aufweisen, die hier im Bereich von etwa 131 kHz und 146 kHz liegen und in Fig. 2 als vertikale Linien dargestellt sind.

Im unteren Teil der Fig. 2 ist ein vergrößerter Ausschnitt des Impedanzverlaufes 30 des Betrages der Impedanz |Z| über einen Frequenzbereich von etwa 75 kHz bis etwa 200 kHz dargestellt. Zur Bestimmung des Impedanzverlaufes 30 in diesem Frequenzbereich kann ein zweites Wechselspannungssignal verwendet werden, das beispielsweise durch das Einkoppelmittel 15 in die Gleichstromleitungen 12a, 12b eingespeist wird. Das zweite Wechselspannungssignal kann verschiedene, insbesondere diskrete Messfrequenzen 32 aufweisen, wobei das zweite Wechselspannungssignal insbesondere zu jedem Zeitpunkt eine einzelne der Messfrequenzen 32 aufweist, um den Betrag der Impedanz |Z| bei dieser einzelnen Messfrequenz zu ermitteln. Grundsätzlich kann das Messsignal jedoch auch mehrere oder alle Messfrequenzen 32 gleichzeitig aufweisen. Der Impedanzverlauf 30 ergibt sich dann durch mehrfache Ermittlung der Impedanzen |Z| bei verschiedenen Messfrequenzen 32, wobei die Messfrequenzen 32 sich über einen Frequenzbereich erstrecken, der die Kommunikationsfrequenzen 31 umfasst und sich insbesondere im Wesentlichen symmetrisch um die Kommunikationsfrequenzen 31 erstreckt.

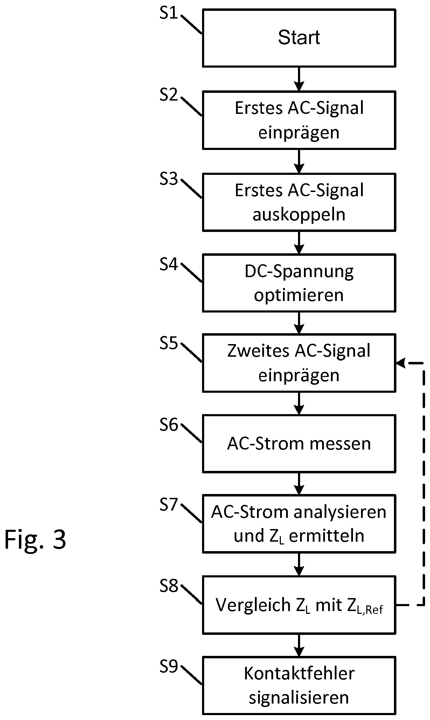

Durch die Anordnung des Auskoppelmittels 16 und des Entkoppelmittels 19 am PV-Generator 11 weist der Impedanzverlauf 30 insbesondere im Bereich der Kommunikationsfrequenzen 31 einen definierten Verlauf auf, der insbesondere weder durch die betriebsabhängige Impedanz des PV-Generators 11 noch durch etwaige höherfrequente Resonanzen der Gleichstromleitungen 12a, 12b beeinflußt ist. Dies ist einerseits notwendig, um eine stabile Kommunikation zwischen dem Einkoppelmittel 15 und dem Auskoppelmittel 16 zu gewährleisten. Andererseits kann diese Eigenschaft vorteilhaft genutzt werden, indem etwaige Kontaktfehler eine Veränderung der Serienimpedanz der Gleichstromleitungen 12a, 12b bewirken, die sich wiederum direkt auf den Impedanzverlauf 30 auswirken und insofern als Änderung des Impedanzverlaufes 30 detektiert werden können. Das entsprechende Verfahren wird im Folgenden in Zusammenhang mit Fig. 3 erläutert.

**Fig. 3** zeigt ein Flussdiagramm eines Ausführungsbeispiels des erfindungsgemäßen Verfahrens. Das Verfahren startet mit Schritt S1, in dem beispielsweise die Photovoltaikanlage 10 insgesamt in Betrieb geht. In Schritt S2 wird ein erstes Wechselspannungssignal (erstes AC-Signal) in einem ersten Frequenzbereich vom Einkoppelmittel 15 in die Gleichstromleitungen 12a, 12b eingeprägt. In Schritt S3 wird das erste Wechselspannungssignal vom Auskoppelmittel 16 ausgekoppelt und von einer elektrischen oder elektronischen Schaltung am PV-Generator 11 derart verwertet, dass ein am PV-Generator angeordneter Freischalter und/oder Kurzschlussschalter in einen Zustand geschaltet wird, der eine Übertragung elektrischer Leistung vom PV-Generator 11 an den Wechselrichter 13 ermöglicht. In Schritt S4 kann dann die elektrische Leistung des PV-Generators 11 insbesondere durch Einstellung der Gleichspannung (DC-Spannung) am Eingang des Wechselrichters 13 optimiert werden, so dass beispielsweise ein Punkt maximaler Leistung auf einer Strom-Spannungskennlinie des PV-Generators 11 eingestellt wird.

In Schritt S5 wird ein zweites Wechselspannungssignal (zweites AC-Signal) in einem zweiten Frequenzbereich vom Einkoppelmittel 15 in die Gleichstromleitungen 12a, 12b eingeprägt, wobei die Frequenz des zweiten Wechselstromsignals über den zweiten Frequenzbereich variiert wird und den ersten Frequenzbereich umfasst. In Schritt S6 wird der Verlauf des aufgrund des zweiten Wechselspannungssignals induzierten Wechselstroms (AC-Strom) in den Gleichstromleitungen 12a, 12b gemessen. In Schritt S7 wird dieser Wechselstromverlauf unter Berücksichtigung der ebenfalls gemessenen Gleichspannung am Eingang des Wechselrichters 13 mittels eines vorab oder situativ bestimmten Modellansatzes analysiert und aus dem Impedanzverlauf 30 die Serienimpedanz Z_{L} der Gleichstromleitungen 12a, 12b ermittelt. Abschließend wird in Schritt S8 die ermittelte Serienimpedanz Z_{L} der Gleichstromleitungen 12a, 12b mit einer Referenz-Serienimpedanz Z_{L,Ref} verglichen, die beispielsweise in einem vorherigen Durchlauf des Verfahrens oder rein analytisch ermittelt wurde, wobei bei diesem vorherigen Durchlauf bzw. dem analytischen Ansatz von fehlerfreien Gleichstromleitungen 12a, 12b ohne Vorhandensein von Kontaktfehlern ausgegangen wird. Alternativ oder zusätzlich kann in Schritt S8 der in Schritt S7 ermittelte Impedanzverlauf 30 einer Mustererkennung unterzogen werden, um einen Kontaktfehler zu erkennen, der ein eindeutiges Muster zum Impedanzverlauf 30 addiert. Wenn in Schritt S8 eine signifikante Änderung der Serienimpedanz festgestellt bzw. ein von einem Kontaktfehler erzeugtes Muster detektiert wird, wird in Schritt S9 das Vorhandensein eines Kontaktfehlers in geeigneter Form signalisiert, beispielsweise an einen Betreiber der Photovoltaikanlage, und die Photovoltaikanlage 10 gegebenenfalls abgeschaltet, insbesondere durch eine Unterbrechung des Gleichstroms in den Gleichstromleitungen 12a, 12b. Wenn in Schritt S8 keine signifikante Änderung der Serienimpedanz festgestellt bzw. kein von einem Kontaktfehler erzeugtes Muster detektiert wird, kann die Photovoltaikanlage 10 weiter betrieben werden und das Verfahren springt zurück zu Schritt S5, um in einem weiteren Durchlauf des Verfahrens, der direkt anschließend oder auch eine gewisse Zeit später, beispielsweise nach einigen Minuten oder Stunden durchgeführt wird, die ermittelte Serienimpedanz Z_{L} zu aktualisieren.

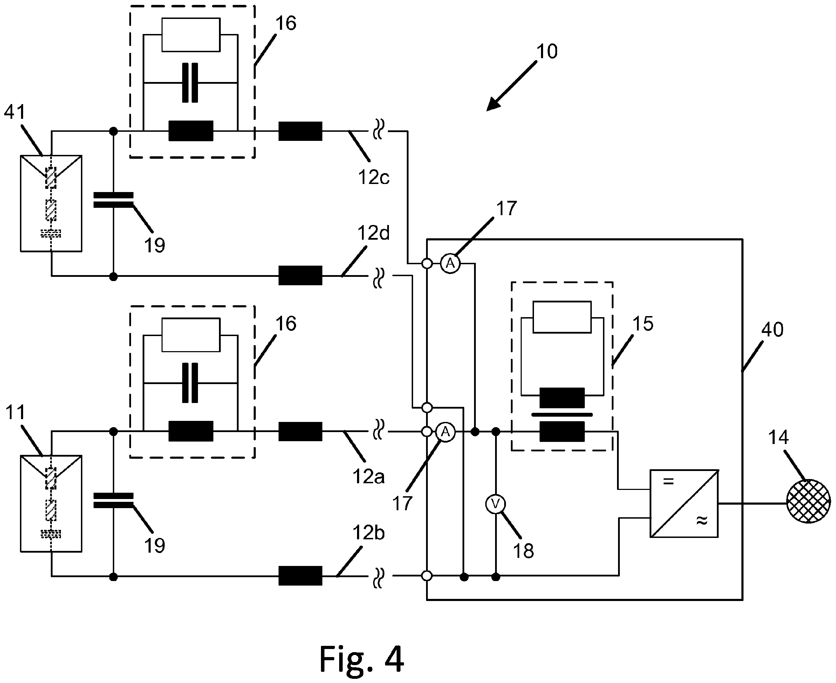

**Fig. 4** zeigt eine weitere Ausführungsform einer Photovoltaikanlage 10 mit einem Wechselrichter 40, der gegenüber dem Wechselrichter 13 gemäß Fig. 1 weitere Gleichstromeingänge aufweist, so dass neben dem PV-Generator 11 ein weiterer PV-Generator 41 über weitere Gleichstromleitungen 12c, 12d an den Wechselrichter 40 angeschlossen werden kann. Der weitere PV-Generator 41 ist innerhalb des Wechselrichters 40 parallel zu dem PV-Generator 11 geschaltet; alternativ kann diese Parallelschaltung auch außerhalb des Wechselrichters 40 stattfinden, beispielsweise in einer hier nicht dargestellten zusätzlichen Anschlusseinheit zur Zusammenführung mehrerer PV-Generatoren 11, 41.

Zur Erkennung von Kontaktfehlern in den Gleichstromleitungen 12a, 12b, 12c, 12d zu den PV-Generatoren 11, 41 ist es notwendig, dass jedem angeschlossenen PV-Generator 11, 41 ein entsprechendes Auskoppelmittel 16, ein Entkoppelmittel 19, sowie ein Strommessmittel 17 zugeordnet ist. Die Erkennung von Kontaktfehlern gestaltet sich dann besonders einfach, da insgesamt nur ein Einkoppelmittel 15 und nur ein Spannungsmessmittel 18 zur Bestimmung der Impedanzverläufe der Übertragungsstrecken zwischen dem Einkoppelmittel 15 und den dann mehreren PV-Generatoren 11, 41 notwendig ist.

### Bezugszeichenliste

- 10: Photovoltaikanlage
- 11: Photovoltaikgenerator
- 12a, 12b: Gleichstromleitungen
- 13: Wechselrichter
- 14: Wechselspannungsnetz
- 15: Einkoppelmittel
- 15a: Wechselspannungsquelle
- 15b: Übertrager
- 16: Auskoppelmittel
- 16a: Induktivität
- 16b: Kapazität
- 16c: Widerstand
- 17: Strommessmittel
- 18: Spannungsmessmittel
- 19: Entkoppelmittel
- 30: Impedanzverlauf
- 31: Kommunikationsfrequenzen
- 32: Messfrequenzen
- 40: Wechselrichter
- 41: Photovoltaikgenerator

## Patentansprüche

1. Verfahren zur Erkennung eines Kontaktfehlers in einer Photovoltaikanlage (10), wobei die Photovoltaikanlage (10) einen Wechselrichter (13) und einen über Gleichstromleitungen (12a, 12b) mit dem Wechselrichter (13) verbundenen Photovoltaikgenerator (11) umfasst, wobei der Wechselrichter (13) Einkoppelmittel (15) zum Einkoppeln eines ersten Wechselspannungssignals mit Kommunikationsfrequenzen (31) in einem ersten Frequenzbereich zwischen 125 und 150 kHz in die Gleichstromleitungen (12a, 12b) umfasst und mittels des ersten Wechselspannungssignals mit dem Photovoltaikgenerator (11) kommuniziert, wobei an dem Photovoltaikgenerator (11) ein Auskoppelmittel (16) zum Auskoppeln des ersten Wechselspannungssignals und zwischen dem Wechselrichter (13) und dem Photovoltaikgenerator (11) ein Entkoppelmittel (19) zur Entkoppelung der Impedanz des Photovoltaikgenerators (11) angeordnet ist, so dass der Photovoltaikgenerator (11) von einer Übertragungsstrecke zwischen Wechselrichter (13) und Entkoppelmittel (19) entkoppelt ist, und wobei Wechselströme in und Wechselspannungen zwischen den Gleichstromleitungen (12a, 12b) gemessen werden,
**dadurch gekennzeichnet, dass**
mittels des Einkoppelmittels (15) ein zweites Wechselspannungssignal mit Messfrequenzen (32) erzeugt wird, wobei mittels des zweiten Wechselspannungssignals und der gemessenen Wechselströme ein frequenzabhängiger Impedanzverlauf (30) in einem zweiten Frequenzbereich zwischen 50 kHz und 350 kHz, bevorzugt zwischen 75 kHz und 200 kHz bestimmt wird, wobei der zweite Frequenzbereich den ersten Frequenzbereich umfasst, und dass ein Kontaktfehler in der Photovoltaikanlage (10) mittels einer Analyse des frequenzabhängigen Impedanzverlaufes (30) erkannt wird.

2. Wechselrichter (13) für eine Photovoltaikanlage (11), wobei der Wechselrichter (13) Einkoppelmittel (15) zum Einkoppeln eines ersten Wechselspannungssignals mit Kommunikationsfrequenzen (31) in einem ersten Frequenzbereich zwischen 125 und 150 kHz und zum Einkoppeln eines zweiten Wechselspannungssignals mit Messfrequenzen (32) in einem zweiten Frequenzbereich zwischen 50 kHz und 350 kHz, bevorzugt zwischen 75 kHz und 200 kHz in die Gleichstromleitungen (12a, 12b) umfasst, wobei der Wechselrichter (13) eine Steuerung umfasst, die dazu eingerichtet ist, ein Verfahren nach Anspruch 1 auszuführen.

3. Wechselrichter (13) nach Anspruch 2, wobei der Wechselrichter (13) Anschlüsse zum Anschluss von mehreren Photovoltaikgeneratoren (11, 41) aufweist, wobei die Photovoltaikgeneratoren (11, 41) innerhalb des Wechselrichters (13) oder in einer zum Wechselrichter (13) gehörigen Anschlusseinheit parallel geschaltet sind und jedem Photovoltaikgenerator je ein Strommessmittel (17) innerhalb des Wechselrichters (13) oder der Anschlusseinheit zugeordnet ist, und wobei das Einkoppelmittel (15) innerhalb des Wechselrichters (13) oder der Anschlusseinheit derart zentral angeordnet ist, dass das erste beziehungsweise das zweite Wechselspannungssignal im Betrieb des Wechselrichters (13) gleichzeitig in die zu den parallel geschalteten Photovoltaikgeneratoren (11, 41) führenden Gleichstromleitungen (12a, 12b, 12c, 12d) eingekoppelt wird.

## Claims

1. A method for detecting a contact fault in a photovoltaic system (10), wherein the photovoltaic system (10) comprises an inverter (13) and a photovoltaic generator (11) connected to the inverter (13) via DC current lines (12a, 12b), wherein the inverter (13) comprises coupling-in means (15) for coupling a first AC voltage signal having communication frequencies (31) in a first frequency range between 125 kHz and 150 kHz into the DC current lines (12a, 12b), wherein the inverter (13) communicates with the photovoltaic generator (11) by way of the first AC voltage signal, wherein a coupling-out means (16) for coupling out the first AC voltage signal is arranged at the photovoltaic generator (11) and a decoupling means (19) for decoupling the impedance of the photovoltaic generator (11) is arranged between the inverter (13) and the photovoltaic generator (11), such that the photovoltaic generator (11) is decoupled from a transmission path between the inverter (13) and the decoupling means (19), and wherein AC currents are measured in the DC current lines (12a, 12b) and AC voltages are measured between the DC current lines (12a, 12b), **characterized in that**
- a second AC voltage signal having measurement frequencies (32) in a second frequency range is generated by way of the coupling-in means (15),
- a frequency-dependent impedance profile (30) is determined based on the second AC voltage signal and the measured AC currents in the second frequency range between 50 kHz and 350 kHz, preferably between 75 kHz and 200 kHz, wherein the second frequency range comprises the first frequency range, and
- a contact fault in the photovoltaic system (10) is detected by way of analyzing the frequency-dependent impedance profile (30).

2. An inverter (13) for a photovoltaic system (11), wherein the inverter (13) comprises coupling-in means (15) for coupling a first AC voltage signal having communication frequencies (31) in a first frequency range between 125 kHz and 150 kHz and a second AC voltage signal having measurement frequencies (32) in a second frequency range between 50 kHz and 350 kHz, preferably between 75 kHz and 200 kHz into the DC current lines (12a, 12b), wherein the inverter (13) comprises a controller that is designed to execute a method as claimed in claim 1.

3. The inverter (13) as claimed in claim 2, wherein the inverter (13) comprises terminals for the connection of a plurality of photovoltaic generators (11, 41), wherein the photovoltaic generators (11, 41) are connected in parallel within the inverter (13) or in a connection unit belonging to the inverter (13) and each photovoltaic generator is assigned a respective current measurement means (17) within the inverter (13) or the connection unit, and wherein the coupling-in means (15) is arranged centrally within the inverter (13) or the connection unit such that the first and the second AC voltage signal are coupled simultaneously into the DC current lines (12a, 12b, 12c, 12d) leading to the parallel-connected photovoltaic generators (11, 41) during operation of the inverter (13).

## Revendications

1. Procédé de détection d'un défaut de contact dans un système photovoltaïque (10), dans lequel le système photovoltaïque (10) comprend un onduleur (13) et un générateur photovoltaïque (11) relié à l'onduleur (13) par des lignes de courant continu (12a, 12b), dans lequel l'onduleur (13) comprend des moyens de couplage (15) pour coupler un premier signal de tension alternative ayant des fréquences de communication (31) dans une première plage de fréquences entre 125 kHz et 150 kHz dans les lignes de courant continu (12a, 12b), dans lequel l'onduleur (13) communique avec le générateur photovoltaïque (11) au moyen du premier signal de tension alternative, dans lequel un moyen de découplage (16) pour découpler le premier signal de tension alternative est disposé sur le générateur photovoltaïque (11) et un moyen de découplage (19) pour découpler l'impédance du générateur photovoltaïque (11) est disposé entre l'onduleur (13) et le générateur photovoltaïque (11), de sorte que le générateur photovoltaïque (11) est découplé d'un chemin de transmission entre l'onduleur (13) et le moyen de découplage (19), et dans lequel les courants alternatifs sont mesurés dans les lignes de courant continu (12a, 12b) et les tensions alternatives sont mesurées entre les lignes de courant continu (12a, 12b),
**caractérisé en ce que**
- un second signal de tension alternative ayant des fréquences de mesure (32) dans une seconde plage de fréquences est généré par le biais du moyen de couplage (15),
- un profil d'impédance dépendant de la fréquence (30) est déterminé sur la base du deuxième signal de tension alternative et des courants alternatifs mesurés dans la deuxième plage de fréquences entre 50 kHz et 350 kHz, de préférence entre 75 kHz et 200 kHz, la deuxième plage de fréquences comprenant la première plage de fréquences, et
- un défaut de contact dans le système photovoltaïque (10) est détecté par l'analyse du profil d'impédance dépendant de la fréquence (30).

2. Onduleur (13) pour une installation photovoltaïque (11), l'onduleur (13) présentant des moyens de couplage (15) pour coupler un premier signal de tension alternative avec des fréquences de communication (31) dans une première plage de fréquences entre 125 kHz et 150 kHz et un deuxième signal de tension alternative avec des fréquences de mesure (32) dans une deuxième plage de fréquences entre 50 kHz et 350 kHz, de préférence entre 75 kHz et 200 kHz, dans les lignes de courant continu (12a, 12b), l'onduleur (13) présentant un régulateur qui est conçu pour exécuter un procédé selon la revendication 1.

3. Onduleur (13) selon la revendication 2, l'onduleur (13) comportant des bornes pour le raccordement de plusieurs générateurs photovoltaïques (11, 41), les générateurs photovoltaïques (11, 41) étant montés en parallèle dans l'onduleur (13) ou dans une unité de raccordement appartenant à l'onduleur (13) et un dispositif de mesure du courant (17) étant associé à chaque générateur photovoltaïque dans l'onduleur (13) ou dans l'unité de raccordement, et dans lequel le moyen de couplage (15) est disposé au centre de l'onduleur (13) ou de l'unité de raccordement de telle sorte que le premier et le deuxième signal de tension alternative sont couplés simultanément dans les lignes de courant continu (12a, 12b, 12c, 12d) menant aux générateurs photovoltaïques (11, 41) montés en parallèle pendant le fonctionnement de l'onduleur (13).
